**Europäisches Patentamt**

**European Patent Office**

**Office européen des brevets**

(19)

(11) Veröffentlichungsnummer: **0 147 514**
**B1**

(12) # EUROPÄISCHE PATENTSCHRIFT

(45) Veröffentlichungstag der Patentschrift:
20.05.87

(51) Int. Cl.⁴: **G 01 B 11/00**

(21) Anmeldenummer: **84107971.8**

(22) Anmeldetag: **07.07.84**

(54) Lichtelektrische Längen- oder Winkelmesseinrichtung.

(30) Priorität: **02.08.83 DE 3327849**

(43) Veröffentlichungstag der Anmeldung:
**10.07.85 Patentblatt 85/28**

(45) Bekanntmachung des Hinweises auf die Patenterteilung:
**20.05.87 Patentblatt 87/21**

(84) Benannte Vertragsstaaten:
**AT CH DE FR GB IT LI NL SE**

(56) Entgegenhaltungen:
**DE-A-3 118 607**
**GB-A-1 312 266**
**US-A-3 815 125**

(73) Patentinhaber: **Dr. Johannes Heidenhain GmbH,
Nansenstrasse 17, D-8225 Traunreut (DE)**

(72) Erfinder: **Huber, Erich, Haus- Nummer 4, D-8221
Schönberg/Gemeinde Kienberg (DE)**

EP 0 147 514 B1

## Beschreibung

Die Erfindung betrifft eine lichtelektrische Längen- oder Winkelmeßeinrichtung gemäß dem Oberbegriff des Anspruchs 1.

Eine derartige Einrichtung ist aus der GB-A- 132 266 bekannt.

Bei lichtelektrischen Meßeinrichtungen wird zur Messung der Relativlage zweier Objekte, beispielsweise zweier Maschinenteile von Bearbeitungsmaschinen, die Teilung eines Maßstabs mittels der Teilung einer Abtastplatte und mittels zugeordneter Photoelemente in einer Abtasteinheit abgetastet. Zur Beleuchtung der Teilungen des Maßstabs und der Abtastplatte ist eine Beleuchtungseinheit in der Abtasteinheit vorgesehen, deren Lichtstrahlen von den Teilungen bei deren Relativbewegung moduliert werden und auf die Photoelemente zur Erzeugung periodischer elektrischer Abtastsignale fallen. Diese Photoelemente sollen von der Beleuchtungseinheit möglichst gleichmäßig beleuchtet werden.

Bei der Verwendung einer handelsüblichen Leuchtdiode in der Beleuchtungseinheit führen aber seitlich aus der Leuchtdiode austretende Lichtstrahlen, die vom Träger der Leuchtdiode oder anderen in der Umgebung befindlichen Bauteilen in Richtung der Teilungen des Maßstabs und der Abtastplatte reflektiert werden, zu einer erheblichen Verschlechterung des Modulationsgrades der periodischen Abtasteignale. Eine Blende, die auf der Lichtaustrittsfläche der Leuchtdiode angebracht ist, kann zwar eine Verbesserung des Modulationsgrades bewirken, hat jedoch zumeist eine starke Verminderung der Amplitude der Abtasteignale zur Folge.

Der Erfindung liegt die Aufgabe zugrunde, bei einer derartigen Längen- oder Winkelmeßeinrichtung eine Beleuchtungeeinheit anzugeben, die die Gewinnung optimaler periodischer Abtastsignale erlaubt.

Diese Aufgabe wird bei einer Einrichtung der eingangs genannten Art erfindungsgemäß durch die kennzeichnenden Merkmale des Anspruchs 1 gelöst.

Die mit der Erfindung erzielten Vorteile bestehen insbesondere darin, daß mit einfachen Mitteln eine Verbesserung der Lichtabstrahlcharakteristik der Beleuchtungseinheit erzielt wird, so daß sich der Modulationsgrad und die Signalamplituden der periodischen Abtastsignale und damit die Meßgenauigkeit und die Meßsicherheit erhöhen.

Vorteilhafte Weiterbildungen der Erfindung entnimmt man den Ansprüchen 2 bis 5.

Ausführungsbeispiele der Erfindung werden anhand der Zeichnung näher erläutert.

Es zeigen

Figur 1 einen Querschnitt durch eine lichtelektrische Längenmeßeinrichtung,

Figur 2 eine schematische Darstellung der lichtelektrischen Längenmeßeinrichtung und

Figur 3 verschiedene Ausbildungen der Beleuchtungseinheit.

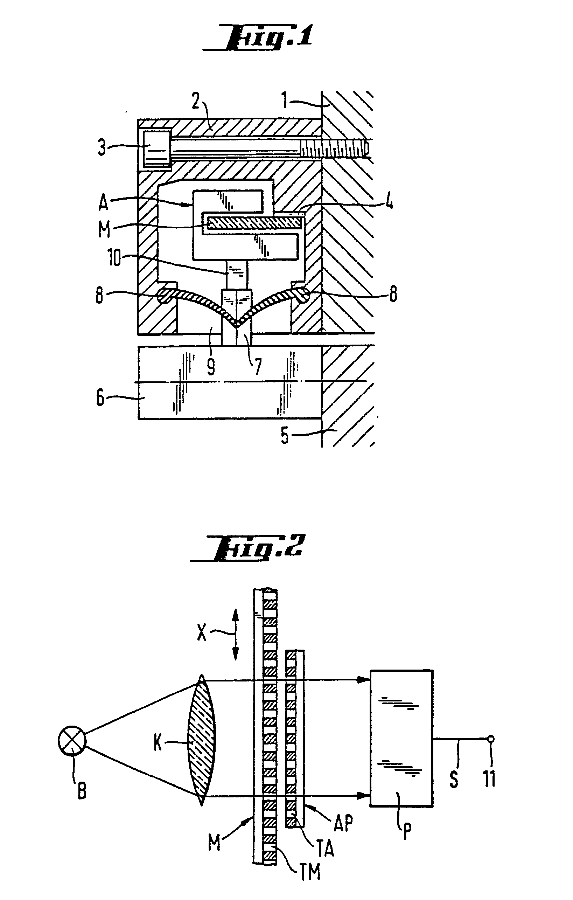

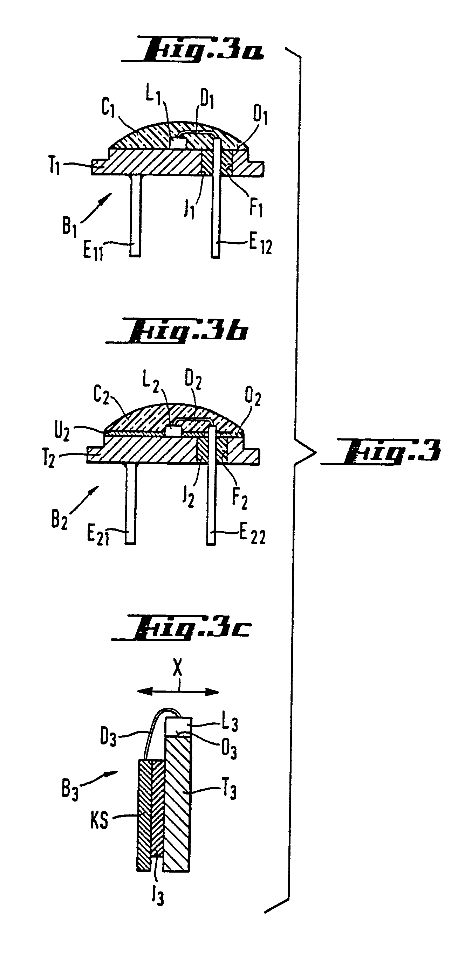

Gemäß Figur 1 ist am Bett 1 einer Bearbeitungsmaschine eine gekapselte lichtelektrische Längenmeßeinrichtung mit einem Gehäuse 2 in Form eines Hohlprofils durch eine Schraube 3 befestigt. In diesem Gehäuse 2 ist mittels einer elastischen Klebeschicht 4 ein Maßstab M mit einer Teilung TM (Figur 2) angebracht, die von einer Abtasteinheit A mit einer Abtastplatte AP abgetastet wird. An einem relativ zum Bett 1 der Maschine beweglichen Schlitten 5 ist ein Montagefuß 6 in beliebiger Weise befestigt, der über eine schwertförmige Verjüngung 7 durch einen mit Dichtlippen 8 versehenen Schlitz 9 des im übrigen vollständig geschlossenen Gehäuses 2 mit einem Mitnehmer 10 verbunden ist, der an der Abtasteinheit A befestigt ist und die Relativbewegung des Schlittens 5 bezüglich des Betts 1 auf die Abtasteinheit A überträgt.

Figur 2 zeigt eine schematische Darstellung der lichtelektrischen Einrichtung der Abtasteinheit A, bei der die Lichtstrahlen einer Beleuchtungseinheit B durch einen Kollimator K, den Maßstab M und die Abtastplatte AP auf ein Photoelement P fallen, das einer Teilung TA der Abtastplatte AP zugeordnet ist. Bei der Bewegung der Abtastplatte AP relativ zum Maßstab M in Meßrichtung X erzeugt das Photoelement P durch die Lichtmodulation an den Teilungen TM, TA ein periodisches elektrisches Abtastsignal S, das über einen Anschluß 11 in nicht dargestellter Weise einer Auswerteeinheit zugeführt wird, die mit einer Anzeigeeinheit zur Anzeige der Position des Schlittens 5 bezüglich des Betts 1 verbunden ist.

In Figur 3 sind verschiedene Ausbildungen der Beleuchtungseinheit B zur Verbesserung der Lichtabstrahlcharakteristik durch Vermeidung von Reflexionen der seitlich aus der Lichtquelle L austretenden Lichtstrahlen in Richtung der Teilungen TM, TA des Maßstabs M und der Abtastplatte AP dargestellt.

Bei der Beleuchtungseinheit $B_1$ gemäß Figur 3a ist auf der Oberfläche $O_1$ eines Trägers $T_1$ eine Leuchtdiode $L_1$ angeordnet. Zur Vermeidung von Reflexionen der seitlich aus der Leuchtdiode $L_1$ austretenden Lichtstrahlen besteht entweder nur die Oberfläche $O_1$ oder der gesamte Träger $T_1$ aus einem lichtabsorbierenden Material. Die Stromversorgung der Leuchtdiode $L_1$ erfolgt über einen ersten Kontaktstift $E_{11}$, der am elektrisch leitenden Träger $T_1$ angelötet ist, und über einen zweiten Kontaktstift $E_{12}$, der durch eine Isolierschicht $I_1$ in einer Bohrung $F_1$ des Trägers $T_1$ hindurchgeführt und über einen Leitungsdraht $D_1$ mit der Leuchtdiode $L_1$ verbunden ist. Zum Schutz des Leitungsdrahtes $D_1$ ist dieser mitsamt der Leuchtdiode $L_1$ in einer Schicht $C_1$ aus lichtdurchlässigem Kunststoff eingebettet.

Bei der Beleuchtungseinheit $B_2$ gemäß Figur 3b ist auf der Oberfläche $O_2$ eines Trägers $T_2$ eine Leuchtdiode $L_2$ angeordnet. Zur Vermeidung von Reflexionen der seitlich aus der Leuchtdiode $L_2$ austretenden Lichtstrahlen ist auf der Oberfläche

$O_2$ des Trägers $T_2$ eine separate Schicht $U_2$ aus lichtundurchläseigen und lichtabsorbierenden Material angeordnet, die die Seitenflächen der Leuchtdiode $L_2$ zumindest teilweise bedeckt. Die Stromversorgung der Leuchtdiode $L_2$ erfolgt über einen ersten Kontaktstift $E_{21}$, der am elektrisch leitenden Träger $T_2$ angelötet ist, und über einen zweiten Kontaktstift $E_{22}$, der durch eine Isolierschicht $I_2$ in einer Bohrung $F_2$ des Trägers $T_2$ hindurchgeführt und über einen Leitungsdraht $D_2$ mit der Leuchtdiode $L_2$ verbunden ist. Zum Schutz des Leitungsdrahtes $D_2$ ist dieser mitsamt der Leuchtdiode $L_2$ in einer Schicht $C_2$ aus lichtdurchlässigem Kunststoff eingebettet.

Bei der Beleuchtungseinheit $B_3$ gemäß Figur 3c ist auf der Oberfläche $O_3$ eines Trägers $T_3$ eine Leuchtdiode $L_3$ angeordnet. Zur Vermeidung von Reflexionen der seitlich aus der Leuchtdiode $L_3$ austretenden Lichtstrahlen weist die Oberfläche $O_3$ des Trägers $T_3$ in Meßrichtung X die gleiche Abmessung wie die Leuchtdiode $L_3$ auf. Die Abmessung der Oberfläche $O_3$ des Trägers $T_3$ senkrecht zur Meßrichtung X kann beliebig, entsprechend einer ausreichenden Stabilität des Trägers $T_3$, gewählt werden. Zur Stromversorgung der Leuchtdiode $L_3$ dient als erster Kontakt der streifenförmige Träger $T_3$ und als zweiter Kontakt ein Kontaktstreifen KS, der über einen Leitungsdraht $D_3$ mit der Leuchtdiode $L_3$ verbunden und gegenüber dem Träger $T_3$ mittele einer Isolierschicht $I_3$ elektrisch isoliert ist.

## Patentansprüche

1. Lichtelektrische Längen- oder Winkelmeßeinrichtung zur Messung der Relativlage zweier Objekte (1, 5), bei der die Teilung (TM) eines mit dem einen Objekt (1) verbundenen Teilungsträgers (M) von einer mit dem anderen Objekt (5) verbundenen Abtasteinheit (A) abgetastet wird, die eine Abtastplatte (AP) mit wenigstens einem zugeordneten Photoelement (P) und eine Beleuchtungseinheit (B) zur Beleuchtung der Teilungen (TM, TA) des Teilungsträgers (M) und der Abtastplatte (AP) aufweist, wobei die Beleuchtungseinheit (B) wenigstens eine auf einem Träger ($T_1$; $T_2$; $T_3$) angeordnete Lichtquelle ($L_1$; $L_2$; $L_3$) aufweist, dadurch gekennzeichnet, daß der Träger ($T_1$; $T_2$; $T_3$) der Lichtquelle ($L_1$; $L_2$; $L_3$) derart ausgebildet ist, daß seitlich aus der Lichtquelle ($L_1$; $L_2$; $L_3$) austretende Lichtstrahlen an diesem Träger ($T_1$; $T_2$; $T_3$) keine Reflexionen in Richtung der Teilungen (TM, TA) des Teilungsträgers (M) und der Abtastplatte (AF) erfahren.

2. Meßeinrichtung nach Anspruch 1, dadurch gekennzeichnet, daß der Träger ($T_1$) der Lichtquelle ($L_1$) eine lichtabsorbierende Oberfläche ($O_1$) aufweist.

3. Meßeinrichtung nach Anspruch 1, dadurch gekennzeichnet, daß auf dem Träger ($T_2$) für die Lichtquelle ($L_2$) eine lichtabsorbierende Schicht ($U_2$) aufgebracht ist.

4. Meßeinrichtung nach Anspruch 1, dadurch gekennzeichnet, daß der Träger ($T_3$) der Lichtquelle ($L_3$) in Meßrichtung (X) die gleiche Abmessung wie die Lichtquelle ($L_3$) aufweist.

5. Meßeinrichtung nach einen der Ansprüche 1 - 4, dadurch gekennzeichnet, daß die Lichtquelle ($L_1$; $L_2$; $L_3$) durch eine Lumineszenzdiode gebildet ist.

## Claims

1. Photoelectric length-measuring or angle-measuring device for the measurement of the relative position of two objects (1, 5), in which device the graduation (TM) of a graduation carrier (M) connected to one of the objects (1) is scanned by a scanning unit (A) connected to the other object (5), which scanning unit(A) exhibits a scanning plate (AP) with at least one associated photoelectric cell (P) and an illumination unit (B) for the illumination of the graduations (TH, TA) of the graduation carrier (M) and of the scanning plate (AP), the illumination unit (B) exhibiting at least one light source ($L_1$; $L_2$; $L_3$) disposed on a carrier ($T_1$; $T_2$; $T_3$), characterized in that the carrier ($T_1$; $T_2$; $T_3$) of the light source ($L_1$; $L_2$; $L_3$) is constructed in such a manner that light rays emerging laterally from the light source ($L_1$; $L_2$; $L_3$) experience at this carrier ($T_1$; $T_2$; T3) no reflections in the direction of the graduations (TM, TA) of the graduation carrier (M) and of the scanning plate (AP).

2. Measuring device according to Claim 1, characterized in that the carrier ($T_1$) of the light source ($L_1$) exhibits a light-absorbing surface ($O_1$).

3. Measuring device according to Claim 1, characterized in that a light-absorbing coating ($U_2$) is applied on the carrier ($T_2$) for the light source ($L_2$).

4. Measuring device according to Claim 1, characterized in that the carrier ($T_3$) of the light source ($L_3$) exhibits the same dimension as the light source (L3) in the measurement direction (X).

5. Measuring device according to one of Claims 1 to 4, characterized in that the light source ($L_1$; $L_2$; $L_3$) is formed by a light-emitting diode.

## Revendications

1. Dispositif photo-électrique de mesure de longueurs ou d'angles, pour la détermination de la position relative de deux objets (1, 5), dans lequel la graduation (TM) d'un support de graduation (M) relié à l'un (1) des deux objets est explorée par une unité exploratrice (A) reliée à l'autre objet (5), laquelle comporte une plaque d'exploration (AP) munie d'au moins une cellule photo-électrique (p) associée à elle ainsi qu'une unité d'éclairage (B), pour les graduations (TM, TA) du support de graduation (M) et de la plaque d'exploration (AP), avec au moins une source lumineuse ($L_1$; $L_2$; $L_3$) placée sur un support ($T_1$; $T_2$; $T_3$), dispositif caractérisé par le fait que le support ($T_1$, $T_2$; $T_3$) de la source lumineuse ($L_1$; $L_2$; $L_3$) est établi en sorte que les rayons lumineux sortant latéralement de cette source lumineuse ($L_1$; $L_2$; $L_3$) ne subissent pas de réflexions en direction des graduations (TM, TA) du support de graduation (M) et de la plaque d'exploration (AF) sur ledit support ($T_1$; $T_2$; $T_3$).

2. Dispositif de mesure selon la revendication 1 caractérisé par le fait que le support ($T_1$) de la source lumineuse ($L_1$) présente une surface ($O_1$) absorbant la lumière.

3. Dispositif de mesure selon la revendication 1 caractérisé par le fait qu'une couche ($U_2$) absorbant la lumière est rapportée sur le support ($T_2$) de la source lumineuse ($L_2$).

4. Dispositif de mesure selon la revendication 1 caractérisé par le fait que le support ($T_3$) de la source lumineuse ($L_3$) présente en direction de mesure (X) la même dimension que ladite source lumineuse ($L_3$).

5. Dispositif de mesure selon l'une des revendications 1-4 caractérisé par le fait que la source lumineuse ($L_1$; $L_2$; $L_3$) est formée d'une diode luminescente.

**Fig.1**

**Fig.2**

## Fig.3a

## Fig.3b

## Fig.3

## Fig.3c